# EUROPEAN PATENT SPECIFICATION

(11) **EP 2 489 541 B1**
(45) Date of publication and mention of the grant of the patent: **02.05.2018**
(21) Application number: 11155060.4
(22) Date of filing: 18.02.2011
(51) Int. Cl.: B60L 1/00

(54) **A safety system for electric and hybrid vehicles**
Sicherheitssystem für Elektro- und Hybridfahrzeuge
Système de sécurité pour véhicules électriques et hybrides

(43) Date of publication of application: 22.08.2012
(73) Proprietor: Tofas Turk Otomobil Fabrikasi Anonim Sirketi, 16369 Bursa (TR)
(72) Inventor: Karakaya, Utku, 16369, Bursa (TR)
(74) Representative: Dericioglu Kurt, Ekin

(56) References cited:
- EP-A2- 0 313 320
- WO-A1-2008/046869
- WO-A2-2009/112165
- GB-A- 2 223 368
- GB-A- 2 465 366
- US-A1- 2009 073 624

## Description

### Field of the Invention

The present invention relates to a safety system which detects the failures occurring in the high voltage line in the electric and hybrid (combined) vehicles.

### Background of the Invention

Today the use of electric vehicles is increasing day by day. Especially it is thought that the hybrid vehicles will mainly be preferred in all vehicle classes in the next years. Because of so many reasons like the transport costs in electric vehicles are lower than the other vehicles, and the electrical vehicles decrease the air pollution, the demand for the said vehicles is increasing day by day.

Devices such as electric machine and drive enabling the wheels to be driven in electric vehicles, air conditioner compressor require high power to be operated. The power provided to the said vehicles is supplied from the electric energy obtained from energy storage systems in other words batteries.

The power transfer between the batteries and the devices requiring high power is performed by means of high voltage line. The said high voltage line comprises electric components such as high voltage cable, generator, contactor, relay and the like. For vehicle safety, it is needed to realize failures such as torn cable that can occur in the high voltage lines, disconnection or break down in connectors which connect the cables to the devices.

In the systems used today, in order to detect the failures that can occur in high voltage line and electric components located in the said line, a low voltage line called HVIL (High Voltage Interlock Loop) is placed on the connectors which connect the high voltage line and the said line. When the connector is dislocated or the cables in the high voltage line are torn, the HVIL line is also wanted to be torn. As a result that the said HVIL line is torn, the relay on the battery is switched on and the high voltage is enabled to be cut off.

Since the HVIL is a separate line, it is not always torn together with the high voltage line. Also if the cable disconnected from the connector when the connector is plugged in, the HVIL is not torn and for this reason the state of the high voltage line cannot be known.

The United States patent document no US2009073624, an application known in the state of the art, discloses HVIL system having a control system which is developed against the failures that can occur in high voltage lines in the electric vehicles. US2009073624 does not show isolators, as defined in claim 1, and the transfer of signals by each of the transmitters via the associated high voltage cable which allows to detect by the receiver whether a failure occurred in one of the high voltage devices or in the high voltage cable associated with that device.

The United States Patent document no US5801615, an application known in the state of the art, discloses a motor vehicle safety system.

Korean Patent document no. KR20080030753, an application known in the state of the art, discloses a safety system which shuts the main power off against the electric shocks and electric leakages in the electric vehicles.

The Chinese Patent document no CN101025436, an application known in the state of the art, discloses a system which controls the high voltage in electric vehicles.

### Summary of the Invention

The objective of the present invention is to realize a safety system which detects the failures that occur in the high voltage line comprising the electric components such as high voltage line, generator, contactor, relay and the like in the electric and the hybrid vehicles.

Another objective of the present invention is to realize a safety system which detects that the failure has occurred in which device or in high voltage line belonging to which device.

A further objective of the present invention is to realize a safety system which gives a visual and/or audial warning in case of a failure.

### Detailed Description of the Invention

A Safety System for Electric and Hybrid Vehicles realized to fulfill the objective of the present invention is illustrated in the accompanying figures, in which,

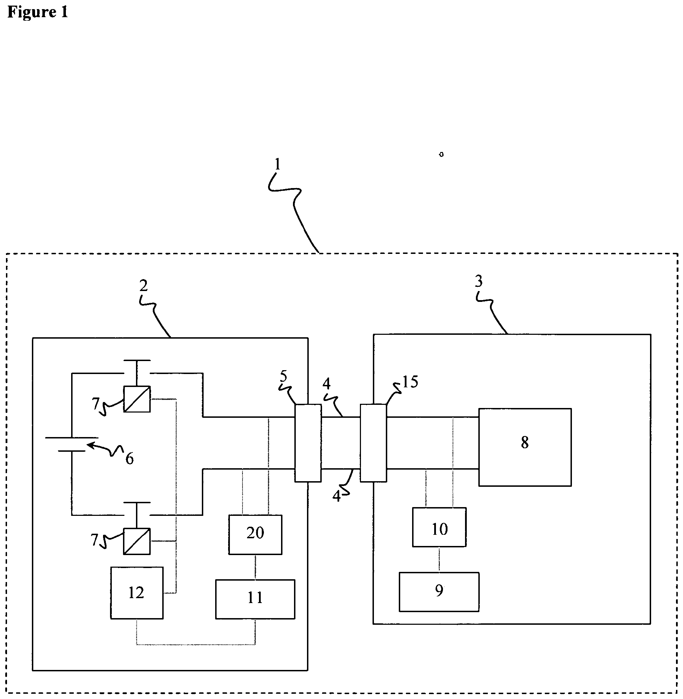

Figure 1 is the schematic view of an inventive safety system.

The components illustrated in the figure are individually numbered where the numbers refer to the following:
1. Safety System
2. Energy Storage Means
3. High voltage device
4. High voltage cable
5, 15. Connection member
6. Generator
7. Switching member
8. Power electronic circuit
9. Transmitter
10, 20. Isolator
11. Receiver
12. Energy management component

The energy storage means (2) supplies electric energy which is required for all kind of devices to be operated in the electric and hybrid vehicles. The energy storage means (2) preferably is a rechargeable battery.

The high voltage device (3) is any kind of device such as electric machine drive, air conditioner compressor, DC/DC converter, power distribution box and the like that needs high voltage to operate. The said high voltage device (3) supplies the electric energy required for its operation from the energy storage means (2) by means of the high voltage cable (4).

The connection members (5, 15) enable the connection of the high voltage cable (4) to the high voltage device (3) and the energy storage means (2) and they preferably are connectors.

Tearing of the high voltage cables (4) enabling the electric energy exchange between the energy storage means (2) and the high voltage device (3) or disconnection of the connection members (5, 15) enabling the connection of the said cables (4) with the said devices (3) in the electric or hybrid vehicles pose a safety threat in the said vehicles. In order that the failures such as the said tearing or disconnection can be realized, a transmitter (9) is placed inside the high voltage device (3) in the inventive system (1). The said transmitter (9) sends signal to the receiver (11) through the high voltage cable (4). If there is any tearing in the cables (4) or a short circuit occurs or the connection members (5, 15) are disconnected, the said signal cannot reach the receiver (11) and the receiver (11) detects that there is a failure.

In the inventive system, the transmitter (9) preferably sends signal via two different methods. The transmitter (9) transmits constant frequency in the first of the said methods. The transmitter (9) transmits sinus wave in a predetermined constant frequency. And the receiver (11) follows the said signal. If a plurality of high voltage devices (3) are connected to the energy storage means (2), there are more than one transmitter (9) and only one receiver (11) present in the system (1). In such situation, in the inventive system, each transmitter (9) transmits sinus wave peculiar to the device (3) in which it is present. The receiver (11) detects from the transmitter (9) in which device (3) the signal is coming by following the sinus wave peculiar to each said device (3). The receiver (11) determines which high voltage device (3) is not connected to the high voltage cable (4) for reasons such as a torn cable (4) or disconnection of connection member (5 or 15) by following the waves in a frequency peculiar to each device (3)simultaneously.

In another signal sending method the transmitter (9) sends digital information through the high voltage cable (4) according to a predetermined communication protocol. The said information includes data peculiar to high voltage device (3). The receiver (11) determines which high voltage device (3) is not connected to the high voltage cable (4) for reasons such as torn cable (4) or disconnection of connection member (5 or 15) by processing the said digital information sent from the transmitter (9).

When the receiver (11) detects which high voltage device (3) is not connected to the high voltage cable (4), it sends the said information to the energy management component (12) and the energy management component (12) stops the high voltage output from the energy storage means (2) by turning the switching member (7) on.

The energy management component (12) also controls the charge level of the energy storage means (2) and protects the energy storage means (2) during charging of the energy storage means (2).

In a preferred embodiment of the present invention, the switching member (7) is a contactor or relay which is resilient to high voltage.

The isolator (10) located in the high voltage device (3) enables the high voltage cable (4) to be isolated from the transmitter (9), the transmitter (9) to be protected from the situations like electrostatic discharge that can occur in the high voltage cable (4) for short time and give harm to the transmitter (9), the signal level transmitted from the transmitter (9) to be amplified

The isolator (20) located in the energy storage means (2) enables the high voltage cable (4) to be isolated from the receiver (11), the receiver (11) to be protected from the situations like electrostatic discharge that can occur in the high voltage cable (4) for short time and give harm to the receiver (11), the signal level transmitted from the transmitter (11) to be amplified before reaching to the receiver (11), the signal received from the transmitter (9) to be filtered, and the DC bias in the signal received from the transmitter (9) to be eliminated.

In the inventive system (1) error control procedure is performed when the vehicle is not operated yet, switching members (7) are on and the high voltage cable (4) is not energized. By this means whether there is an error is detected before the energy is transferred to the high voltage devices (3). In order to perform the said procedure, the receiver (11) checks whether a signal is received from the transmitter (9) and the energy management component (12) waits until the information that there is no error in the high voltage line is received from the receiver (11). The energy management component (12) enables the switching members (7) to be turned off and the energy to be transferred to the high voltage devices (3) when the energy management component (12) receives the information that there is no error from the receiver (11). By this means the system (1) performs a pre control procedure.

The receiver (11) monitors the distortions, damages and the weaknesses in the signal it receives from the transmitter (9). The receiver (11) decides what kind of a failure has occurred depending on the said monitoring. The receiver (11) can detect a loosening belonging to the connection member (5, 15) as a result of the said monitorings. In such case the receiver (11) enables the driver to be warned about there is not a torn cable (4), there is loosening of the connection member (5 or 15) and the said problem is to be solved.

In an embodiment of the present invention, at least one warning unit (not shown in the figures) which is placed to the instrument panel of the vehicle or a place inside vehicle which the driver can see easily and gives audial and/or visual warning, is used. The receiver (11) is connected to the warning unit with or without wire and enables the driver to be informed via the warning unit visually and/or aurally about which device (3) is not operating.

In a preferred embodiment of the invention the inventive safety system (1) is used in the electric vehicles.

In an embodiment of the invention the inventive safety system (1) is used in the hybrid vehicles.

By means of the inventive system (1) failures occurring in the high voltage line that includes the electric components in the electric and hybrid vehicles. That the said failures have occurred in which device (3) or in the high voltage line belonging to which device (3) is detected and visual and/or audial warning is given.

Within the scope of this basic concept, it is possible to develop various embodiments of the inventive safety system for electric and hybrid vehicles (1). The invention can not be limited to the examples described herein; it is essentially according to the claims.

## Claims

1. A safety system (1) detecting failures occurring in an high voltage cable of an electric and hybrid vehicles; **comprising**
- an energy storage means (2) wherein the high power required for the electric and hybrid vehicle is supplied,
- at least one high voltage device (3) each connected with a high voltage cable (4) to the energy storage means (2), which at least one high voltage cable (4) enables the electric energy to be transferred to the associated high voltage device (3) from the energy storage means (2),
- at least one first connection member (5) which enables the connection of each high voltage cable (4) to the energy storage means (2),
- a generator (6) which is located inside the energy storage means (2), enables the load transfer by creating potential difference and both ends of which are connected to the at least one high voltage cable (4),
- at least one switching member (7) which enables the electric energy wanted to be transferred anytime from the generator (6) to the at least one high voltage cable (4) or to cut the said electric energy off,
- a power electronic circuit (8) which is located in each high voltage device (3), enables the electric energy transferred via the associated high voltage cable (4) to be converted efficiently into electrical output form desired for the high voltage device (3) to be operated, and
- at least one second connection member (15) which enables the connection of the high voltage cable (4) with the associated high voltage device (3),
- a transmitter (9) which is located inside each of the at least one high voltage device (3) in a way isolated from the associated high voltage cable (4), such as to protect the transmitter (9) from disturbances on the voltage cable (4), and which is adapted to send a signal through the associated high voltage cable (4),
- a receiver (11) which is located in the energy storage means (2) in a way isolated from the at least one high voltage cable (4), such as to protect the receiver from disturbances on the at least one high voltage cable (4), and which is adapted to receive the signal sent from each of the at least one transmitter (9) and to detect that there is a failure in a device or in the high voltage cable belonging to said device if the signal does not reach the receiver (11) from the at least one transmitter (9) by processing the signal sent by the at least one transmitter (9), and
- an energy management component (12) which is located in the energy storage means (2) between the receiver (11) and the at least one switching member (7) and adapted to stop the high voltage output from the energy storage means (2) to the failed device or high voltage cable belonging to said device by turning off the at least one switching member (7) when it receives an information from the receiver (11) that there is a failure.

2. A safety system (1) according to claim 1, **characterized in that** energy storage means (2) is a rechargeable battery.

3. A safety system (1) according to claim 1 or 2, **characterized in that** the at least one transmitter (9) transmits sinus wave in a constant frequency peculiar to the device (3) in which it is located.

4. A safety system (1) according to claim 3, **characterized in that** the receiver (11) detects from which transmitter the signal is coming by following the sinus wave peculiar to the associated device (3).

5. A safety system (1) according to any of the preceding claims, **characterized in that** transmitter (9) sends digital information including the data peculiar to the associated high voltage device (3) through the high voltage cable (4) according to a predetermined communication protocol.

6. A safety system (1) according to any of the claims, **characterized in that** energy management component (12) controls the charge level of the energy storage means (2) and protects the energy storage means (2) during charging of the energy storage means (2).

7. A safety system (1) according to any of the preceding claims, **characterized in that** the at least one switching member (7) is a contactor.

8. A safety system (1) according to any of the claims 1 to 8, **characterized in that** the at least one switching member (7) is a relay.

9. A safety system (1) according to any of the preceding claims, **characterized in that** each isolator (10) enables the high voltage cable (4) to be isolated from the associated transmitter (9), is adapted to protect the associated transmitter (9) from the situations like electrostatic discharge that can occur in the high voltage cable (4) for short time and give harm to the transmitter (9), the signal level transmitted from the transmitter (9) to be amplified.

10. A safety system (1) according to any of the preceding claims, **characterized in that** isolator (20) which enables the at least one high voltage cable (4) to be isolated from the receiver (11), is adapted to protect the receiver (11) from the situations like electrostatic discharge that can occur in the at least one high voltage cable (4) for short time and give harm to the receiver (11), the signal level transmitted from the at least one transmitter (11) to be amplified before reaching to the receiver (11), the signal received from the transmitter (9) to be filtered, and the DC bias in the signal received from the transmitter (9) to be eliminated.

11. A safety system (1) according to any of the preceding claims, **characterized in that** the energy management component (12) waits until the information that there is no error in the at least one high voltage cable (4) is received from the receiver (11) in order to perform error control procedure when the vehicle is not operated yet, at least one switching member (7) is off and the high voltage cable (4) is not energized; enables the at least one switching member (7) to be closed and energy to be transferred to the at least one high voltage device (3) when said energy management component (12) receives the information there is no error from the receiver (11); and realizes a pre control process by this means.

12. A safety system (1) according to any of the preceding claims, **characterized in that** the receiver (11), when it detects distortions, damages and weakness in the signal from said at least one transmitter (9), decides that there is loosening at the connection of the cables (4) belonging to the associated high voltage device (3).

13. A safety system (1) according to any of the preceding claims, **characterized in that** the at least one warning unit is placed to the instrument panel of the vehicle or a place inside vehicle which the driver can see easily, gives audial and/or visual warning.

14. A safety system (1) according to any of the preceding claims, **characterized in that** the receiver (11) which is connected to the warning unit with or without wire and enables the driver to be informed via the warning unit visually and/or aurally about which device (3) is not operating.

15. A safety system (1) according to any of the preceding claims, **characterized in that** the said first and/or second connection member (5, 15) is a connector.

16. An electric vehicle using a safety system (1) according to any of the preceding claims.

17. A hybrid vehicle using a safety system (1) according to any of the claims 1 to 16.

## Patentansprüche

1. Ein Sicherheitssystem (1), das Fehler erkennt, die in einem Hochspannungskabel eines Elektro- und Hybridfahrzeugs auftreten; **umfassend**
- ein Energiespeichermittel (2), wobei die für das Elektro- und Hybridfahrzeug erforderliche hohe Leistung geliefert wird,
- mindestens eine Hochspannungseinrichtung (3), die jeweils mit einem Hochspannungskabel (4) mit dem Energiespeichermittel (2) verbunden ist, wobei mindestens ein Hochspannungskabel (4) die Übertragung der elektrischen Energie auf die zugehörige Hochspannungseinrichtung (3) aus dem Energiespeichermittel (2) ermöglicht,
- mindestens ein erstes Verbindungselement (5), das die Verbindung jedes Hochspannungskabels (4) mit dem Energiespeichermittel (2) ermöglicht,
- einen Generator (6), der innerhalb des Energiespeichermittels (2) angeordnet ist, der die Lastumschaltung erlaubt, indem er Potentialdifferenz erzeugt, und dessen beiden Enden mit mindestens einem Hochspannungskabel (4) verbunden sind,
- mindestens ein Schaltelement (7), das es ermöglicht, dass die elektrische Energie jederzeit von dem Generator (6) zu dem mindestens ein Hochspannungskabel (4) übertragen werden kann oder die elektrische Energie abgeschaltet werden kann,
- eine leistungselektronische Schaltung (8), die sich in jeder Hochspannungseinrichtung (3) befindet, die es ermöglicht, dass die über das zugehörige Hochspannungskabel (4) übertragene elektrische Energie effizient in eine für die Hochspannungseinrichtung (3) gewünschte elektrische Leistung umgesetzt wird, um diese zu bedienen,
- mindestens ein zweites Verbindungselement (15), das die Verbindung des Hochspannungskabels (4) mit der zugehörigen Hochspannungseinrichtung (3) ermöglicht,
- einen Sender (9), der sich innerhalb jeder der mindestens eine Hochspannungseinrichtung (3) isoliert von dem zugeordneten Hochspannungskabel (4) befindet, um den Sender (9) vor Störungen am Spannungskabel (4) zu schützen, und der dazu geeignet ist, ein Signal durch das zugeordnete Hochspannungskabel (4) zu senden
- einen Empfänger (11), der in dem Energiespeichermittel (2) so angeordnet ist, dass er von mindestens einem Hochspannungskabel (4) isoliert ist, sodass der Empfänger vor Störungen an dem mindestens ein Hochspannungskabel (4) zu schützen, und der dazu ausgelegt ist, das von jedem der mindestens einen Sender (9) gesendete Signal zu empfangen und zu erkennen, dass ein Fehler in einem Gerätespannungskabel, das zu dem Gerät gehört, auftritt, wenn das Signal von dem mindestens einen Sender (9) der Empfänger (11) nicht erreicht, indem das von dem mindestens einen Sender (9) gesendeten Signal verarbeitet wird, und
- eine Energiemanagementkomponente (12), die im Energiespeichermittel (2) zwischen dem Empfänger (11) und dem mindestens einen Schaltelement (7) angeordnet ist und die zum Stoppen des Hochspannungsausgangs von dem Energiespeichermittel (2) zur defekten Vorrichtung oder dem Hochspannungskabel, das der Vorrichtung gehört, durch Ausschalten mindestens einen Schaltelements (7) angepasst ist, wenn es eine Information von dem Empfänger (11) empfängt, dass ein Fehler vorliegt.

2. Sicherheitssystem (1) nach Anspruch 1 **dadurch gekennzeichnet, dass** das Energiespeichermittel (2) eine wiederaufladbare Batterie ist.

3. Sicherheitssystem (1) nach Anspruch 1 oder 2 **dadurch gekennzeichnet, dass** mindestens ein Sender (9) eine Sinuswelle in einer konstanten Frequenz sendet, die der Vorrichtung (3), in der er sich befindet, eigen ist.

4. Sicherheitssystem (1) nach Anspruch 3 **dadurch gekennzeichnet, dass** der Empfänger (11) erkennt, von welchem Sender das Signal kommt, indem er die Sinuswelle folgt, die der zugeordneten Vorrichtung (3) eigen ist.

5. Sicherheitssystem (1) nach einem der vorangehenden Ansprüche, **dadurch gekennzeichnet, dass** der Sender (9) digitale Information, einschließlich Daten, die der zugeordneten Hochspannungseinrichtung (3) eigen sind, über das Hochspannungskabel (4) nach einem vorbestimmten Kommunikationsprotkoll sendet.

6. Sicherheitssystem (1) nach einem der Ansprüche, **dadurch gekennzeichnet, dass** die Energiemanagementkomponente (12) das Ladungsniveau des Energiespeichermittels (2) steuert und den Energiespeicher (2) während des Ladens des Energiespeichermittels (2) schützt.

7. Sicherheitssystem (1) nach einem der vorangehenden Ansprüche, **dadurch gekennzeichnet, dass** mindestens ein Schaltelement (7) ein Schütz ist.

8. Sicherheitssystem (1) nach einem der Ansprüche 1 bis 8, **dadurch gekennzeichnet, dass** mindestens ein Schaltelement (7) ein Relais ist.

9. Sicherheitssystem (1) nach einem der vorangehenden Ansprüche, **dadurch gekennzeichnet, dass** jeder Isolator (10) es ermöglicht, dass das Hochspannungskabel (4) von dem zugehörigen Sender (9) isoliert ist, dazu angepasst ist, den zugeordneten Sender (9) von Situationen, wie elektrostatische Entladung, zu schützen, welche im Hochspannungskabel (4) kurzzeitig auftreten kann und dem Sender (9) schaden kann, Signalniveau vom Sender (9) übertragen wird, der amplifiziert werden soll.

10. Sicherheitssystem (1) nach einem der vorangehenden Ansprüche, **dadurch gekennzeichnet, dass** der Isolator (20) die Isolation des mindestens ein Hochspannungskabels (4) von der Empfänger (11) ermöglicht, zum Schutz des Empfängers (11) vor Situationen wie elektrostatische Entladung, die im mindestens ein Hochspannungskabel (4) kurzzeitig auftreten und den Empfänger (11) schaden kann, angepasst ist, Signalniveau, das von dem mindestens einen Empfänger (11) gesendet wird, um vor dem Erreichen des Empfängers (11) amplifiziert zu werden, das Signal, das von dem Sender (9) empfangen wird zu filtern, und Gleichstrom (DC)-Vorspannung in dem Signal, das von dem Sender (9) empfangen wird, zu eliminieren.

11. Sicherheitssystem (1) nach einem der vorangehenden Ansprüche, **dadurch gekennzeichnet, dass** die Energiemanagementkomponente (12) wartet, bis die Information, dass kein Fehler in dem mindestens ein Hochspannungskabel (4) vorliegt, vom Empfänger (11) empfangen wird, um einen Fehlerkontrollvorgang durchzuführen, wenn das Fahrzeug noch nicht betrieben ist, ist mindestens ein Schaltglied (7) ausgeschaltet und das Hochspannungskabel (4) ist nicht erregt; ermöglicht, dass das mindestens ein Schaltelement (7) geschlossen ist und die Energie zur mindestens ein Hochspannungseinrichtung (3) übertragen wird, wenn Energiemanagementkomponente (12) die Information empfängt, dass kein Fehler von dem Empfänger (11) vorliegt, und einen Vorsteuerprozess auf diese Weise erkennt.

12. Sicherheitssystem (1) nach einem der vorangehenden Ansprüche, **dadurch gekennzeichnet, dass** der Empfänger (11), wenn er Verzerrungen, Beschädigungen und Schwäche des Signals von dem mindestens einen Sender (9) erkennt, entscheidet, dass eine Lockerung am Anschluss von Kabeln (4), die dem zugeordneten Hochspannungsgerät (3) gehören, erfolgt.

13. Sicherheitssystem (1) nach einem der vorangehenden Ansprüche, **dadurch gekennzeichnet, dass** mindestens eine Warneinheit an der Instrumenttafel des Fahrzeugs oder an einem Ort innerhalb des Fahrzeugs angeordnet ist, den der Fahrer leicht sehen kann, der akustische und/ oder visuelle Warnung abgibt.

14. Sicherheitssystem (1) nach einem der vorangehenden Ansprüche, **dadurch gekennzeichnet, dass** der Empfänger (11), der mit der Warneinheit mit oder ohne Kabel verbunden ist und es dem Fahrer ermöglicht, sich über die Warneinheit optisch und / oder akustisch darüber zu informieren, welches Gerät (3) nicht arbeitet.

15. Ein Sicherheitssystem (1) nach einem der vorangehenden Ansprüche, **dadurch gekennzeichnet, dass** das erste und/ oder zweite Verbindungselement (5, 15) einen Verbinder ist.

16. Ein Elektrofahrzeug mit einem Sicherheitssystem (1) nach einem der vorangehenden Ansprüche.

17. Hybridfahrzeug mit einem Sicherheitssystem (1) nach einem der Ansprüche 1 bis 16.

## Revendications

1. Système de sécurité (1) détectant les défaillances se produisant dans un câble haute tension d'un véhicule électrique et hybride; **comprenant**
- un moyen de stockage d'énergie (2) dans lequel la puissance élevée requise pour le véhicule électrique et hybride est fournie,
- au moins un dispositif à haute tension (3) relié chacun avec un câble haute tension (4) aux moyens de stockage d'énergie (2), au moins un câble haute tension (4) permet de transférer l'énergie électrique vers le dispositif à haute tension associé (3) à partir des moyens de stockage d'énergie (2),
- au moins un premier élément de connexion (5) qui permet la connexion de chaque câble haute tension (4) aux moyens de stockage d'énergie (2),
- un générateur (6) qui est situé à l'intérieur des moyens de stockage d'énergie (2), permet le transfert de charge en créant une différence de potentiel et dont les deux extrémités sont connectées au moins un câble haute tension (4),
- au moins un membre de commutation (7) permettant de transférer à tout moment l'énergie électrique voulue du générateur (6) au moins un câble haute tension (4) ou de couper ladite énergie électrique,
- un circuit électronique de puissance (8) situé dans chaque dispositif à haute tension (3) permet de convertir efficacement l'énergie électrique transmise par le câble haute tension associé (4) en une forme de sortie électrique souhaitée pour le dispositif à haute tension (3) être exploité, et
- au moins un deuxième élément de connexion (15) qui permet la connexion du câble haute tension (4) avec le dispositif à haute tension associé (3),
- un émetteur (9) qui est situé à l'intérieur de chacun des au moins un dispositif à haute tension (3) isolé du câble haute tension associé (4), de façon à protéger l'émetteur (9) des perturbations sur le câble de tension (4), et qui est adapté pour envoyer un signal à travers le câble haute tension associé (4)
- un récepteur (11) qui est situé dans les moyens de stockage d'énergie (2) d'une manière isolée du au moins un câble haute tension (4), de façon à protéger le récepteur des perturbations sur le au moins un câble haute tension (4), et qui est adapté pour recevoir le signal envoyé par chacun des au moins un émetteur (9) et pour détecter qu'il y a une défaillance dans un câble de tension de dispositif faisant partie dudit dispositif si le signal me n'atteint pas le récepteur (11) à partir du au moins un émetteur (9) en traitant le signal envoyé par le au moins un émetteur (9), et
- un composant de gestion d'énergie (12) qui est situé dans les moyens de stockage d'énergie (2) entre le récepteur (11) et le au moins un membre de commutation (7) et adapté pour arrêter la sortie haute tension des moyens de stockage d'énergie (2) au dispositif fixe ou au câble haute tension appartenant audit dispositif en fermant l'au moins un membre de commutation (7) lorsqu'il reçoit une information de la part du récepteur (11) qu'il y a une défaillance.

2. Système de sécurité (1) selon la revendication 1, **caractérisé en ce que** le moyen de stockage d'énergie (2) est une batterie rechargeable.

3. Système de sécurité (1) selon la revendication 1 ou 2, **caractérisé en ce que** le au moins un émetteur (9) transmet une onde sinusoïdale à une fréquence constante propre au dispositif (3) dans lequel il est situé.

4. Système de sécurité (1) selon la revendication 3, **caractérisé en ce que** le récepteur (11) détecte de quel émetteur le signal provient en suivant l'onde sinusoïdale propre au dispositif associé (3).

5. Système de sécurité (1) selon l'une quelconque des revendications précédentes, **caractérisé en ce que** l'émetteur (9) envoie des informations numériques comprenant les données particulières au dispositif à haute tension (3) associé par le câble haute tension (4) selon une communication prédéterminée protocole.

6. Système de sécurité (1) selon l'une quelconque des revendications, **caractérisé en ce que** le composant de gestion d'énergie (12) contrôle le niveau de charge des moyens de stockage d'énergie (2) et protège les moyens de stockage d'énergie (2) pendant la charge des moyens de stockage d'énergie (2).

7. Système de sécurité (1) selon l'une quelconque des revendications précédentes, **caractérisé en ce que** le au moins un membre de commutation (7) est un contacteur.

8. Système de sécurité (1) selon l'une quelconque des revendications 1 à 8, **caractérisé en ce que** le au moins un membre de commutation (7) est un relais.

9. Système de sécurité (1) selon l'une quelconque des revendications précédentes, **caractérisé en ce que** chaque isolateur (10) qui permet d'isoler le câble haute tension (4) de l'émetteur associé (9), est adapté pour protéger l'émetteur associé (9) des situations telles qu'une décharge électrostatique qui peut se produire dans le câble haute tension (4) pendant un court instant et endommager l'émetteur (9), le niveau de signal transmis par l'émetteur (9) être amplifié.

10. Système de sécurité (1) selon l'une quelconque des revendications précédentes, **caractérisé en ce que** l'isolateur (20) qui permet de séparer le au moins un câble haute tension (4) du récepteur (11), est adapté pour protéger le récepteur (11) des situations telles qu'une décharge électrostatique qui peut se produire dans le au moins un câble haute tension (4) pendant une courte durée et causer des dommages au récepteur (11), le niveau de signal transmis depuis le au moins un émetteur (11) à amplifier avant d'atteindre le récepteur (11), le signal reçu de l'émetteur (9) à filtrer et la polarisation continue (DC) dans le signal reçu de l'émetteur (9) à éliminer.

11. Système de sécurité (1) selon l'une quelconque des revendications précédentes, **caractérisé en ce que** le composant de gestion d'énergie (12) attend jusqu'à ce que l'information indiquant qu'il n'y a pas d'erreur dans le au moins un câble haute tension (4) soit reçue du récepteur (11) afin d'effectuer une procédure de contrôle d'erreur lorsque le véhicule n'est pas encore utilisé, au moins un membre de commutation (7) est éteint et le câble haute tension (4) n'est pas alimenté; permet de fermer l'au moins un membre de commutation (7) et de transférer l'énergie au moins un dispositif à haute tension (3) lorsque ledit composant de gestion d'énergie (12) reçoit l'information il n'y a pas d'erreur du récepteur (11) et réalise un processus de contrôle préalable par ce moyen.

12. Système de sécurité (1) selon l'une quelconque des revendications précédentes, **caractérisé en ce que** le récepteur (11), lorsqu'il détecte des distorsions, des dommages et une faiblesse du signal provenant dudit au moins un émetteur (9), décide qu'il se desserre à la connexion des câbles (4) appartenant au dispositif à haute tension associé (3).

13. Système de sécurité (1) selon l'une quelconque des revendications précédentes, **caractérisé en ce que** la au moins une unité d'avertissement est placée sur le tableau de bord du véhicule ou un endroit à l'intérieur du véhicule que le conducteur peut voir facilement, donne un avertissement auditif et / ou visuel.

14. Système de sécurité (1) selon l'une quelconque des revendications précédentes, **caractérisé en ce que** le récepteur (11) est relié à l'avertisseur avec ou sans fil et permet au conducteur d'être informé visuellement et / ou quel appareil (3) ne fonctionne pas.

15. Système de sécurité (1) selon l'une quelconque des revendications précédentes, **caractérisé en ce que** ledit premier et / ou ledit deuxième élément de connexion (5, 15) est un connecteur.

16. Véhicule électrique utilisant un système de sécurité (1) selon l'une quelconque des revendications précédentes.

17. Véhicule hybride utilisant un système de sécurité (1) selon l'une quelconque des revendications 1 à 16.
